# EUROPÄISCHE PATENTSCHRIFT

(11) **EP 3 163 637 B1**
(45) Veröffentlichungstag und Bekanntmachung des Hinweises auf die Patenterteilung: **29.03.2023**
(21) Anmeldenummer: 16195204.9
(22) Anmeldetag: 24.10.2016
(51) Int. Cl.: H01L 33/50, H01L 25/075, H01L 33/54

(54) **WEISSES LICHT ABSTRAHLENDES LED-MODUL**
LED MODULE EMITTING WHITE LIGHT
MODULE À DEL ÉMETTANT UNE LUMIÈRE BLANCHE

(30) Priorität: 26.10.2015 DE 202015105686 U
(43) Veröffentlichungstag der Anmeldung: 03.05.2017
(73) Patentinhaber: Tridonic GmbH & Co KG, 6851 Dornbirn (AT)
(72) Erfinder: LOCHMANN, Frank, D-88147 Achberg (DE); MOOSMANN, Florian, 6835 Zwischenwasser (AT); MARTE, Patrick, A-6840 Götzis (AT); SZÜCS, Anna, A-8380 Jennersdorf (AT)
(74) Vertreter: Rupp, Christian

(56) Entgegenhaltungen:
- EP-A2- 2 637 224
- WO-A1-2014/202456
- WO-A1-2015/082032
- US-A1- 2010 025 700
- US-A1- 2011 037 081
- US-A1- 2011 121 758
- US-A1- 2014 111 985
- US-A1- 2015 021 635

## Beschreibung

Die vorliegende Erfindung betrifft ein weißes Licht abstrahlendes LED-Modul.

Ferner bezieht sich die vorliegende Erfindung auf ein derartiges LED-Modul, welches hinsichtlich der Farbkoordinaten des von ihm emittierten weißen Lichts veränderbar ist.

Es ist aus dem Stand der Technik bekannt, weißes Licht eines LED-Moduls aus dem Licht einer roten, einer grünen und einer blauen LED zu mischen. Dabei werden auch Leuchtstoffe oder Leuchtstoffmischungen eingesetzt - und z.B. auf eine oder mehrere der LEDs oder auf Bereiche von LEDs aufgebracht - um wärmeres oder kälteres weißes Licht erzeugen zu können. Außerdem kann abhängig von der Stärke der Ansteuerung der einzelnen LEDs eine Farbtemperatur bzw. ein Farbton des weißen Lichts des bekannten LED-Moduls verändert werden.

Nachteilig bei diesem weißes Licht abstrahlenden LED-Modul ist, dass es kompliziert und aufwendig ist, die Leuchtstoffe oder Leuchtstoffmischungen präzise auf die LEDs bzw. auf die Bereiche der LEDs aufzubringen. Außerdem ist auch eine Verkleinerung der Lichtabstrahlfläche für dieses LED-Modul nur begrenzt möglich. Zudem kann die Farbtemperatur des LED-Moduls nur in einem relativ engen Bereich und darin nur in diskreten Schritten verändert werden. Auch nachteilig ist, dass die blauen und roten LEDs eine unterschiedliche Temperaturabhängigkeit haben, wodurch der Farbton des LED-Moduls während des Betriebs nicht stabil ist.

Es ist ferner aus dem Stand der Technik bekannt, weißes Licht eines LED-Moduls aus dem Licht einer kaltweißen LED und einer warmweißen LED zu mischen. Dabei ist jede der LEDs mit einer Abdeckung versehen, insbesondere mit einem Globe-Top über der LED. Ein Globe-Top enthält dabei einen Leuchtstoff zum Erzeugen des kaltweißen Lichts und der andere Globe-Top enthält einen Leuchtstoff zum Erzeugen des warmweißen Lichts. Um die Farbtemperatur bzw. einen Farbpunkt des weißen Lichts des LED-Moduls einzustellen werden die beiden LEDs über einen Treiber mit zwei Ausgangsstufen angesteuert.

Nachteilig bei diesem weißes Licht abstrahlenden LED-Modul ist, dass das abgestrahlte Licht relativ inhomogen ist und die Homogenität nur mit Hilfe eines Diffusers oder dergleichen gewährleistet werden kann. Weißes Licht abstrahlende LED-Module sind in den Dokumenten WO 2014/202456 A1, EP 2 637 224 A2, US 2014/111985 A1 und US 2011/037081 A1 jeweils offenbart.

Ausgehend von den bekannten LED-Modulen und deren Nachteilen ist es nun Aufgabe der vorliegenden Erfindung, ein verbessertes weißes Licht abstrahlendes LED-Modul herzustellen. Insbesondere sollen ein Farbpunkt und die Farbtemperatur des weißen Lichts in einem Bereich von 2000-6500 K stufenlos einstellbar sein. Das Einbringen von Leuchtstoff in das LED-Modul soll ferner vereinfacht sein. Außerdem soll die Skalierbarkeit des LED-Moduls hin zu kleineren Größen, insbesondere Lichtabstrahlflächen einfacher zu erreichen sein. Ein weiteres Ziel ist eine bessere Farbdurchmischung für ein homogeneres weißes Licht des LED-Moduls. Dabei sollen insbesondere keine Diffusoren notwendig sein, die einen Effizienzverlust des LED-Moduls mit sich bringen.

Die oben genannten Aufgaben werden durch die vorliegende Erfindung gemäß dem unabhängigen Anspruch gelöst. Weitere vorteilhafte Ausführungsformen der Erfindung werden in den abhängigen Ansprüchen definiert.

Dabei ist erfindungsgemäß eine einzige Abdeckung über einer LED-Chip Anordnung aus wenigstens zwei LED-Chips vorgesehen, wobei die Abdeckung wenigstens zwei unterschiedliche Leuchtstoffe aufweist.

Die vorliegende Erfindung betrifft ein weißes Licht abstrahlendes LED-Modul, aufweisend wenigstens einen ersten LED-Chip und wenigstens einen zweiten LED-Chip, eine Abdeckung, welche alle LED-Chips abdeckt und mit wenigstens zwei unterschiedlichen Leuchtstoffen versehen ist, wobei wenigstens ein Leuchtstoff dazu geeignet ist, Strahlung des ersten LED-Chips zumindest teilweise in ein erstes Licht umzuwandeln, wenigstens ein anderer Leuchtstoff dazu geeignet ist, Strahlung des zweiten LED-Chips zumindest teilweise in ein zweites Lichts umzuwandeln, das weiße Licht des LED-Moduls zumindest das erste und das zweite Licht enthält, und Farbkoordinaten des weißen Lichts durch Einstellen der Intensität und/oder Wellenlänge der Strahlung des ersten und/oder zweiten LED-Chips veränderbar sind.

Dadurch, dass nur eine einzige Abdeckung verwendet wird, die vorzugsweise eine homogene Leuchtstoffschicht über oder Leuchtstoffumhüllung um alle LED-Chips darstellt, kann ein homogeneres weißes Licht aufgrund einer besseren Farbmischung erreicht werden. Dazu ist insbesondere kein Diffuser oder dergleichen nötig. Die einzige im LED-Modul verwendete Abdeckung macht es auch deutlich einfacher die verschiedenen Leuchtstoffe einzubringen. Die verschiedenen Leuchtstoffe müssen insbesondere nicht an gezielten Bereiche angeordnet werden, sondern können gleichverteilt, als Leuchtstoffmischung in die Abdeckung eingebettet werden oder auf diese aufgebracht werden.

Durch Einstellen der Intensität und/oder Wellenlänge der Strahlung von wenigstens einem LED-Chip ist mit der vorliegenden Erfindung der Farbpunkt - bspw. im CIE-Diagramm - bzw. jede Farbtemperatur des weißen Lichts zwischen 2000-6500 K einstellbar. Um die Intensität und/oder Wellenlänge eines LED-Chips einzustellen bzw. zu vergrößern oder zu verschieben, kann dieser LED-Chip selektiv entweder durchgehend oder gepulst angesteuert werden.

Die Abdeckung ist ein Globe-Top, vorzugsweise ein über alle LED-Chips dispensierter Globe-Top, oder, in einem nicht beanspruchten Beispiel, ist die Abdeckung eine Füllung eines durch Dämmen-und-Füllen hergestellten LED-Moduls.

Ein solcher über alle LED-Chips dispensierter Globe-Top, der die wenigstens zwei verschiedenen Leuchtstoffe aufweist, ist einfach herzustellen und auch auf oder über sehr kleinen Lichtabstrahlflächen anzuordnen. Dadurch ist auch eine Verkleinerung des LED-Moduls oder von Lichtabstrahlflächen einfacher möglich. Die verschiedenen Leuchtstoffe lassen sich vorteilhafterweise in dem Material des Globe-Tops verteilen, bevor dieser über die LED-Chips dispensiert wird. Es können alternativ oder zusätzlich auch Leuchtstoffschichten auf dem Globe-Top aufgebracht werden. Dieselben Vorteile sind auch erzielbar für ein LED-Modul, das durch Dämmen und Füllen hergestellt ist. Dabei werden zunächst ein oder mehrere Dämme hergestellt, vorzugsweise wird ein alle LED-Chips umschließender ringförmiger Damm hergestellt, und dann als Abdeckung die Füllung mit den vorzugsweise darin verteilten Leuchtstoffen zwischen den oder die Dämme eingefüllt.

Vorteilhafterweise ist die Intensität der Strahlung des ersten und/oder zweiten LED-Chips durch Amplituden- oder Pulsweiten-Modulation veränderbar, und/oder ist der Wellenlängenbereich der Strahlung des ersten und/oder zweiten LED-Chips über den Vorwärtsstrom veränderbar.

Die selektive Ansteuerung der LED-Chips mit einem AM- oder PWM-Signal bzw. die selektive Ansteuerung durch eine Veränderung des Vorwärtsstroms ist gezielt und jederzeit während des Betriebs des LED-Moduls möglich. So kann der Farbpunkt im CIE Diagramm bzw. die Farbtemperatur des weißen Lichts mindestens zwischen 2000-6500 K stufenlos verändert werden.

Vorteilhafterweise überlappt ein Anregungsspektrum des einen Leuchtstoffs nicht mit einem Emissionsspektrum des anderen Leuchtstoffs.

Dadurch kann eine separierte Anregung der unterschiedlichen Leuchtstoffe ermöglicht werden. Dies kann beispielweise durch gezielte Lücken im Anregungsspektrum eines oder beider Leuchtstoffe erreicht werden. Zumindest ein Leuchtstoff ist vorteilhafterweise nicht oder nur wenig anregbar durch die Strahlung eines der wenigstens zwei LED-Chips.

Der erste LED-Chip ist dazu geeignet, blaues Licht auszusenden, der zweite LED-Chip ist dazu geeignet, UV Strahlung oder violettes Licht auszusenden, ein erster Leuchtstoff ist dazu geeignet, das blaue Licht des ersten LED-Chips und/oder die UV Strahlung oder das violette Licht des zweiten LED-Chips zumindest teilweise in grünes, grünlich-gelbes, gelblich-grünes und/oder gelbes erstes Licht umzuwandeln, und ein zweiter Leuchtstoff ist dazu geeignet, die UV Strahlung oder das violette Licht des zweiten LED-Chips oder das blaue Licht des ersten LED-Chips zumindest teilweise in rotes zweites Licht umzuwandeln.

Das weißes Licht abstrahlende LED-Modul enthält also zumindest einen grün, grünlich-gelb, gelblich-grün und/oder gelb leuchtenden Leuchtstoff und einen rot leuchtenden Leuchtstoff. Dadurch kann eine angenehm warme Farbtemperatur des einstellbaren weißen Lichts erzielt werden.

Vorteilhafterweise ist der erste Leuchtstoff dazu geeignet, das blaue Licht des ersten LED-Chips und/oder das violette Licht des zweiten LED-Chips nur teilweise in das erste Licht umzuwandeln, so dass eine Mischung des nicht umgewandelten Lichts und des ersten Lichts ein weißes Licht ergibt, wobei das weiße Licht des LED-Moduls zumindest das weiße Licht bestehend aus dem nicht umgewandelten Licht und dem ersten Licht sowie das zweite Licht enthält.

Der Farbpunkt bzw. die Farbtemperatur des weißen Lichts des LED-Moduls kann nun insbesondere dadurch verändert werden, dass selektiv entweder durchgehend oder beispielsweise in der Art einer PWM-Modulation nur der zweite bzw. der erste LED-Chip angesteuert wird. Dadurch kann die Intensität und/oder Wellenlänge der vom zweiten bzw. ersten LED-Chip abgegebenen Strahlung und somit der Anteil des roten zweiten Lichts eingestellt bzw. verändert werden, wodurch sich der Farbpunkt bzw. die Farbtemperatur des weißen Lichts des LED-Moduls ändert.

Vorteilhafterweise ist die Abdeckung mit einem dritten Leuchtstoff versehen, wobei der dritte Leuchtstoff dazu geeignet ist, das blaue Licht des ersten LED-Chips und/oder die UV Strahlung oder das violette Licht des zweiten LED-Chips zumindest teilweise in grünes, grünlich-gelbes, gelblich-grünes und/oder gelbes drittes Licht umzuwandeln, und das weiße Licht des LED-Moduls das dritte Licht enthält.

Vorzugsweise umfasst der dritte Leuchtstoff ein mit seltenen Erden dotiertes Granat, vorzugsweise YAG:Ce³⁺, oder LuAG:Ce³⁺, oder ein mit seltenen Erden dotiertes Orthosilikat, vorzugsweise B.O.S.E.

Unter B.O.S.E. versteht man Orthosilikate gemäß den Formeln (Ca, Sr, Ba)₂SiO₄:Eu²⁺, (Ca, Sr,)₂SiO₄:Eu²⁺, Ba₂SiO₄:Eu²⁺, Sr₂SiO₄:Eu²⁺, (Sr, Ba)₂SiO₄:Eu²⁺ oder (Ca, Ba)₂SiO₄:Eu²⁺.

Durch den zusätzlichen dritten Leuchtstoff kann die Farbtemperatur des weißen Lichts weiter verbessert werden. Insbesondere wird der Farbwiedergabeindex des Lichts des LED-Moduls verbessert, wenn sowohl das blaue Licht des ersten LED-Chips als auch die UV Strahlung bzw. das violette Licht des zweiten LED-Chips einen Leuchtstoff anregen, der grünes, grünlich-gelbes, gelblich-grünes und/oder gelbes Licht abgibt. In anderen Worten, wenn das Licht bzw. die Strahlung aus beiden LED-Chips zumindest zum Teil in grünes, grünlich-gelbes, gelblich-grünes und/oder gelbes Licht umgewandelt wird. Dies kann durch einen breitbandig anregbaren Leuchtstoff oder durch zwei verschiedene, unterschiedlich anregbare Leuchtstoffe realisiert werden. Ferner wird auch die Einstellbarkeit des Farbpunkts bzw. der Farbtemperatur zwischen 2000-6500 K weiter vereinfacht.

Wenigstens zwei Leuchtstoffe, bspw. der erste oder zweite Leuchtstoff und der dritte Leuchtstoff, können vorteilhafterweise durch einen einzigen Leuchtstoff realisiert werden. Das bedeutet es kann ein spezieller Leuchtstoff verwendet werden, der bspw. sowohl durch blaues Licht als auch durch violettes Licht oder UV-Strahlung anregbar ist. Dies verringert die Komplexität des Systems und ist beispielsweise durch eine gezielte Dotierung eines bekannten YAG-Leuchtstoffs mit einer seltenen Erde wie z.B. Ce³⁺ möglich.

Der erste LED-Chip ist dazu geeignet, blaues Licht mit einem Intensitätsmaximum in einem Wellenlängenbereich von 455 - 475 nm auszusenden, und ist der zweite LED-Chip dazu ist geeignet, violettes Licht mit einem Intensitätsmaximum in einem Wellenlängenbereich von 380 - 410 nm, vorzugsweise bei einer Wellenlänge von etwa 405 nm, auszusenden.

Ein derartiges LED-Modul hat den Vorteil, dass die einzelnen LED-Chips einfach und billig verfügbar sind. Insbesondere können der erste und zweite LED-Chip auf GaN basierte LED-Chips sein. Des Weiteren sind für solche LED-Chips auch geeignete Leuchtstoffe zur Umsetzung der vorliegenden Erfindung gut verfügbar.

Vorteilhafterwiese umfasst der erste Leuchtstoff ein mit seltenen Erden dotiertes Granat, vorzugsweise YAG:Ce³⁺, oder LuAG:Ce³⁺, oder ein mit seltenen Erden dotiertes Orthosilikat, vorzugsweise B.O.S.E. ((Ca, Sr, Ba)₂SiO₄:Eu²⁺, (Ca, Sr,)₂SiO₄:Eu²⁺, Ba₂SiO₄:Eu²⁺, Sr₂SiO₄:Eu²⁺, (Sr, Ba)₂SiO₄:Eu²⁺), (Ca, Ba)₂SiO₄:Eu²⁺)), und umfasst der zweite Leuchtstoff ein mit Mangan dotiertes KSF oder ein mit seltenen Erden dotiertes Nitrid.

In diesem Fall kann der erste Leuchtstoff das Licht des violetten LED-Chips und der zweite Leuchtstoff das Licht des blauen LED-Chips wenigstens zum Teil umwandeln. Wird beispielsweise ein Orthosilikat, etwa nach einer der Formel (Ca, Sr, Ba)₂SiO₄:Eu²⁺, (Ca, Sr,)₂SiO₄:Eu²⁺, Ba₂SiO₄:Eu²⁺, Sr₂SiO₄:Eu²⁺, (Sr, Ba)₂SiO₄:Eu²⁺), (Ca, Ba)₂SiO₄:Eu²⁺) als erster Leuchtstoff verwendet, der durch das violette Licht des zweiten LED-Chips anregbar ist, so kann bereits durch den violetten LED-Chip und den ersten Leuchtstoff ein weißes Licht erzeugt werden. Das rote Licht des zweiten Leuchtstoffs, der durch das blaue Licht des ersten LED-Chips anregbar ist, dient dann dazu, den Farbpunkt bzw. die Farbtemperatur des weißen Lichts des LED-Moduls ins wärmere zu verschieben und die Farbtemperatur einzustellen. Beispielsweise kann für den zweiten Leuchtstoff K₂(SiF₆):Mn⁴⁺ oder (Sr, Ca)AlSiN₃:Eu²⁺ oder CaAlSiN₃:Eu²⁺ verwendet werden.

In einem nicht beanspruchten Beispiel ist der erste LED-Chip dazu geeignet, blaues Licht mit einem Intensitätsmaximum in einem Wellenlängenbereich von 455 - 475 nm auszusenden, und ist der zweite LED-Chip dazu geeignet, UV Strahlung mit einem Intensitätsmaximum in einem Wellenlängenbereich von 230 - 280 nm auszusenden.

Für dieses LED-Modul wird beispielsweise ein blauer GaN LED-Chip und ein ultravioletter AlGaN LED-Chip verwendet. Die Emissionswellenlänge des AlGaN LED-Chips ist vorzugsweise durch Veränderung des Vorwärtsstroms zwischen 230-280 nm einstellbar.

Vorteilhafterweise ist die Abdeckung mit wenigstens einem UV-absorbierenden Stoff versehen, vorzugsweise mit TiO₂ und/oder Al₂O₃.

Der UV absorbierende Stoff wird eingesetzt, um nicht umgewandelte UV-Strahlung zu filtern, die unter Umständen ungewünscht für das menschliche Auge sein kann. Vorteilhafterweise umfasst der erste Leuchtstoff ein mit seltenen Erden dotiertes Granat, vorzugsweise YAG:Ce³⁺, oder LuAG:Ce³⁺, oder ein mit seltenen Erden dotiertes Orthosilikat, vorzugsweise B.O.S.E. (bspw. (Ba, Sr)₂SiO₄:Eu²⁺), und umfasst der zweite Leuchtstoff ein mit seltenen Erden dotiertes Granat, vorzugsweise YAG:Eu³⁺, oder ein mit seltenen Erden dotiertes Yttrium-Oxid, vorzugsweise Y₂O₃:Eu³⁺.

In diesem Fall kann der erste Leuchtstoff das Licht des blauen LED-Chips und der zweite Leuchtstoff das Licht des UV LED-Chips umwandeln. Beispielsweise kann als erster Leuchtstoff ein YAG:Ce³⁺verwendet werden, der bei einer Wellenlänge von 230-280 nm keine bzw. nur wenig Anregung zeigt (also quasi nur durch den blauen LED-Chip angeregt wird). Als zweiter Leuchtstoff kann dann Y₂O₃:Eu3⁺ verwendet, das bei einer Wellenlänge von 455-475 nm keine bzw. nur wenig Anregung zeigt (also quasi nur durch den UV LED-Chip angeregt wird). Der Hauptanteil des weißen Lichts des LED-Moduls stammt dann durch das erste Licht, also dem blauen Licht des ersten LED-Chips und dem grünen bzw. gelben Licht des YAG:Ce³⁺, während eine Farbverschiebung ins rötliche durch das Licht abgegeben vom Y₂O₃:Eu³⁺ erreicht wird. Je nach Ansteuerung der einzelnen LEDs-Chips kann eine solche Lichtüberlagerung verändert werden, um einen Farbpunkt bzw. eine Farbtemperatur des weißen Lichts des LED-Moduls einzustellen.

In einem nicht beanspruchten Beispiel ist der erste und der zweite LED-Chip dazu geeignet, UV Strahlung auszusenden, wobei ein erster Leuchtstoff und ein zweiter Leuchtstoff zusammen dazu geeignet sind, die UV Strahlung des ersten bzw. zweiten LED-Chips zumindest teilweise umzuwandeln, so dass eine Mischung aus dem ersten und dem zweiten Licht ein weißes Licht ergibt.

Vorteilhafterweise ist der erste LED-Chip dazu geeignet, UV Strahlung mit einem Intensitätsmaximum in einem Wellenlängenbereich von 320 - 360 nm auszusenden, und ist der zweite LED-Chip dazu geeignet, UV Strahlung mit einem Intensitätsmaximum in einem Wellenlängenbereich von 230 - 280 nm auszusenden. Vorteilhafterweise umfasst der erste Leuchtstoff ein mit seltenen Erden dotiertes Granat, vorzugsweise YAG:Ce³⁺, oder LuAG:Ce³⁺, oder ein mit seltenen Erden dotiertes Orthosilikat, vorzugsweise B.O.S.E., und umfasst der zweite Leuchtstoff ein mit seltenen Erden dotiertes Yttrium-Oxid, vorzugsweise Y₂O₃:Eu³⁺, Vorteilhafterweise weist das LED-Modul ferner wenigstens einen dritten LED-Chip auf, der dazu geeignet ist, blaues Licht auszusenden, wobei das weiße Licht des LED-Moduls zumindest das weiße Licht bestehend aus dem ersten und dem zweiten Lichts sowie das blaue Licht des dritten LED-Chips enthält.

Der zusätzliche blaue LED-Chip wird derart verwendet, dass das von ihm abgegebene blaue Licht im Wesentlichen nicht umgewandelt wird und deshalb zu dem weißen Licht des LED-Moduls beiträgt. Der dritte LED-Chip kann wiederum einzeln angesteuert werden, wodurch die Veränderung des Farbpunktes bzw. der Farbtemperatur des weißen Lichts des LED-Moduls noch variabler wird.

In einem nicht beanspruchten Beispiel ist der erste und der zweite LED-Chip dazu geeignet, blaues Licht auszusenden, wobei der erste Leuchtstoff dazu geeignet ist, das blaue Licht des ersten LED-Chips nur teilweise umzuwandeln, so dass eine Mischung aus dem nicht umgewandelten blauen Licht des ersten LED-Chips und dem ersten Licht ein wärmeres weißes Licht ergibt, wobei der zweite Leuchtstoff dazu geeignet ist, das blaue Licht des zweiten LED-Chips nur teilweise umzuwandeln, so dass eine Mischung aus dem nicht umgewandelten blauen Licht des zweiten LED-Chips und dem zweiten Licht ein kälteres weißes Licht ergibt, und wobei das weiße Licht des LED-Moduls zumindest das wärmere und das kältere weiße Licht enthält.

Durch gezielte Ansteuerung des das wärmere weiße Licht produzierenden LED-Chips bzw. des das kältere weiße Licht produzierenden LED-Chips kann der Farbpunkt bzw. die Farbtemperatur des weißen Lichts des LED-Moduls eingestellt werden.

Vorteilhafterweise ist der erste LED-Chip dazu geeignet, blaues Licht mit einem Intensitätsmaximum in einem Wellenlängenbereich von 400 - 440 nm auszusenden, und ist der zweite LED-Chip dazu geeignet, blaues Licht mit einem Intensitätsmaximum in einem Wellenlängenbereich von 430 - 470 nm auszusenden. Derartige blaue LED-Chips sind einfach und billig erhältlich. Vorheilhaft ist, dass auch keinerlei UV-Licht abgegeben wird.

Die vorliegende Erfindung wird nun detailliert im Bezug auf die beigefügten Figuren beschrieben.
Figur 1 zeigt ein LED-Modul gemäß der vorliegenden Erfindung.
Figur 2 zeigt ein LED-Modul mit zwei Leuchtstoffen in einem Globe-Top gemäß der vorliegenden Erfindung.
Figur 3 zeigt ein LED-Modul mit drei Leuchtstoffen in einem Globe-Top gemäß der vorliegenden Erfindung.
Figur 4 ein durch Dämmen und Füllen hergestelltes LED-Modul.
Figur 5 zeigt ein Anregungs- und Emissionsspektrum eines ersten YAG-Leuchtstoffs.
Figur 6 zeigt ein Anregungs- und Emissionsspektrum eines zweiten YAG-Leuchtstoffs.
Figur 7 zeigt ein Anregungs- und Emissionsspektrum eines B.O.S.E.-Leuchtstoffs.
Figur 8 zeigt ein Anregungs- und Emissionsspektrum eines B.O.S.E.-Leuchtstoffs.
Figur 9 zeigt ein Anregungs- und Emissionsspektrum Orthosilikat-Leuchtstoffs.
Figur zeigt 10 ein Anregungs- und Emissionsspektrum eines KSF-Leuchtstoffs.
Figur 11 zeigt ein Anregungs- und Emissionsspektrum eines mit seltenen Erden dotierten Nitrid-Leuchtstoffs.
Figur 12 zeigt ein Anregungs- und Emissionsspektrum eines mit seltenen Erden dotierten YEO-Leuchtstoffs (Yttrium-Oxid).
Figur 13 zeigt ein Anregungs- und Emissionsspektrum eines dritten YAG-Leuchtstoffs.
Figur 14 zeigt ein Anregungs- und Emissionsspektrum eines LUAG-Leuchtstoffs.

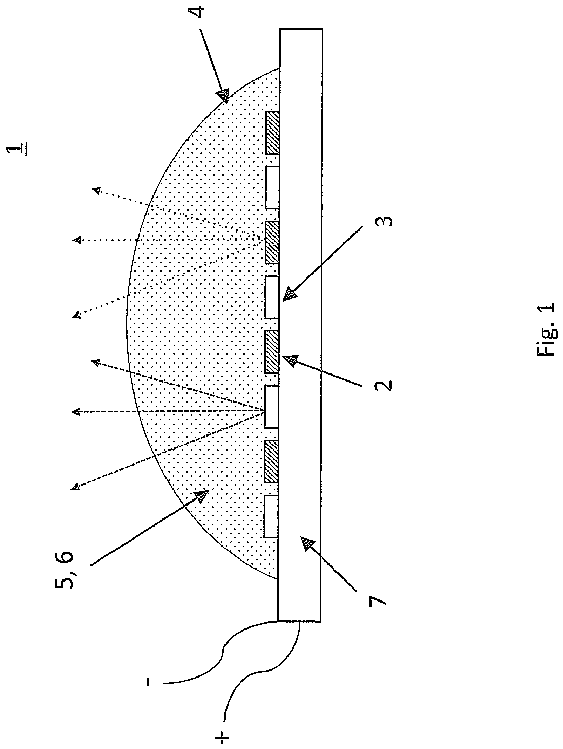

Ein erfindungsgemäßes weißes Licht abstrahlendes LED-Modul 1 ist in Fig. 1 gezeigt.

Das LED-Modul 1 weist zumindest einen ersten LED-Chip 2 auf und weist zumindest einen zweiten LED-Chip 3 auf. Gezeigt sind beispielhaft vier erste LED-Chips 2 und vier zweite LED-Chips 3. Der wenigstens eine erste LED-Chip 2 sendet im Betrieb des LED-Moduls 1 Strahlung einer ersten Wellenlänge bzw. eines ersten Wellenlängenbereichs aus, während der wenigstens eine zweite LED-Chip 3 Strahlung einer zweiten Wellenlänge bzw. eines zweiten Wellenlängenbereichs aussendet.

Der erste LED-Chip 2 ist ein blauer LED-Chip, der blaues Licht in einem Bereich von 455-475 nm aussendet. Der zweite LED-Chip 3 ist ein violetter LED-Chip, der violettes Licht in einem Bereich von 380-410 nm aussendet, oder, in einem nicht beanspruchten Beispiel, ist ein UV LED-Chip, der UV-Strahlung in einem Bereich von vorzugsweise 230-280 nm aussendet.

Das LED-Modul 1 weist ferner eine Abdeckung 4 auf, welche alle LED-Chips 2, 3, abdeckt. In Fig. 1 ist die Abdeckung 4 ein Globe-Top über alle LED-Chips 2, 3.

Vorzugsweise ist die Abdeckung 4 in diesem Fall ein über alle LED-Chips 2, 3 dispensierter Globe-Top.

Die Abdeckung 4 ist zumindest mit einem ersten Leuchtstoff 5 und einem zweiten Leuchtstoff 6 versehen (bspw. versetzt, vermischt oder überzogen), die Abdeckung 4 weist also wenigstens zwei unterschiedliche Leuchtstoffe 5, 6 auf. Die Abdeckung 4 ist dabei vorzugsweise homogen mit den beiden Leuchtstoffen 5, 6 versehen, insbesondere homogen über alle LED-Chips 2,3 bzw. deren Abstrahlwinkel. Wenigstens einer der Leuchtstoffe 5, 6 ist dazu geeignet Strahlung des ersten LED-Chips 2 zumindest teilweise in ein erstes Licht umzuwandeln und wenigstens ein anderer Leuchtstoff 5, 6 ist dazu geeignet, Strahlung des zweiten LED-Chips 3 zumindest teilweise in ein zweites Lichts umzuwandeln

Ein erster Leuchtstoff 5 ist dazu geeignet, das von dem ersten LED-Chip 2 und/oder zweiten LED-Chip 3 ausgesandte Licht zumindest teilweise in erstes Licht einer dritten Wellenlänge bzw. eines dritten Wellenlängenbereichs umzuwandeln. Der Leuchtstoff kann das vom LED-Chip 2, 3 abgegebene Licht auch komplett in das erste Licht umwandeln. Dazu ist der erste Leuchtstoff 5 ein Leuchtstoff, der im grünen, grünlich-gelben, gelblich-grünen und/oder gelben Wellenlängenbereich (also etwa zwischen etwa 510-580 nm) auf Anregung hin abstrahlt.

Ein zweiter Leuchtstoff 6 ist dazu geeignet, die von dem zweiten LED-Chip 3 und/oder die von dem ersten LED-Chip 2 abgegebene Strahlung bzw. Licht zumindest teilweise in zweites Licht einer vierten Wellenlänge bzw. eines vierten Wellenlängenbereichs umzuwandeln. Der zweite Leuchtstoff 6 kann das vom LED-Chip 3, 2 ausgesandte Licht bzw. Strahlung auch komplett in das zweite Licht umwandeln. Der zweite Leuchtstoff 6 ist ein Leuchtstoff, der auf Anregung hin ein Licht im roten Wellenlängenbereich abgibt.

Das insgesamt vom LED-Modul 1 abgegebene Licht enthält dann zumindest das erste Licht, welches von dem ersten Leuchtstoff 5 abgegeben wird, und das zweite Licht, welches von dem zweiten Leuchtstoff 6 abgegeben wird. Dadurch wird ein warmes weißes Licht erzielt. Wandeln die Leuchtstoffe 5, 6 entweder beide oder wenigstens einer von ihnen das Anregungslicht nicht komplett um, so mischt sich zu dem weißen Licht des LED-Moduls 1 noch die vom ersten LED-Chip 2 abgegebene Strahlung bzw. die vom zweiten LED-Chip 3 abgegebene Strahlung.

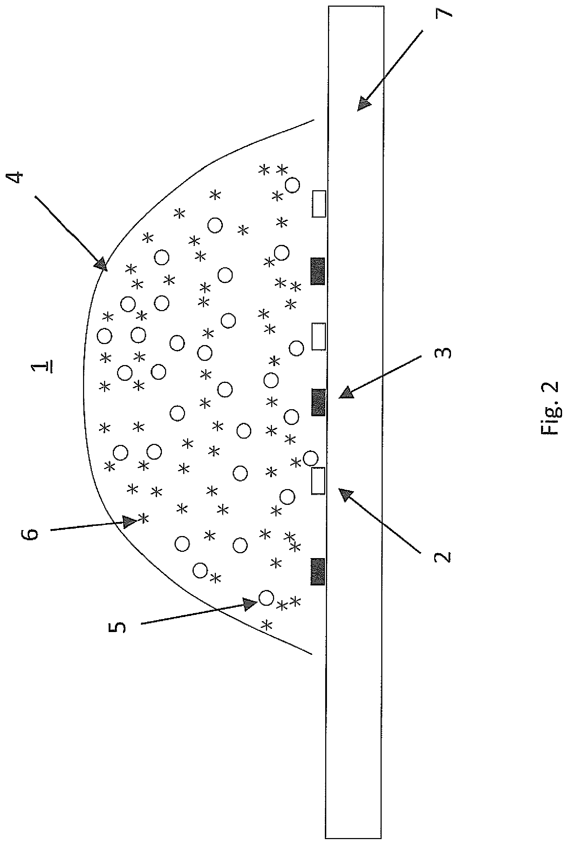

In Fig. 1 sind Anschlüsse an die LED-Chips 2, 3 gezeigt, mit denen die LED-Chips 2,3 entweder individuell oder gemeinschaftlich ansteuerbar sind. Insbesondere ist das LED-Modul 1 mit entsprechenden Einrichtungen versehen, um die LEDs 2, 3 - entweder einzeln oder alle zusammen - durch Amplituden-Modulation (AM-Modulation) oder durch Pulsweiten-Modulation (PWM-Modulation) anzusteuern, oder einen Vorwärtsstrom durch die LED-Chips 2, 3 zu verändern. Dadurch ist es möglich, die Intensität der Strahlung der einzelnen LED-Chips 2, 3 bzw. eine Wellenlänge der Strahlung (bzw. einen Wellenlängenbereich) der einzelnen LED-Chips 2, 3 gezielt zu verändern. Durch diese gezielte Veränderung können die Farbkoordinaten des LED-Moduls 1, der Farbpunkt in einem Farbdiagramm wie CIE-Diagramm und/oder die Farbtemperatur des weißen Lichts des LED-Modul 1, in einem Bereich von wenigstens 2000-6500 K stufenlos eingestellt werden. In Fig. 2 sind die einzelnen LED-Chips 2, 3 auf einer Basisplatte 7, beispielsweise einem FR4 PCB angeordnet.

Fig. 2 zeigt ein ähnliches weißes Licht abstrahlendes LED-Modul 1 wie es in Figur 1 gezeigt ist. In der Abdeckung 4, die in Fig. 2 auch ein Globe-Top ist, sind zwei verschiedenen Leuchtstoffe 5 bzw. 6 gezeigt.

Der erste Leuchtstoff 5 kann ein mit seltenen Erden dotiertes Granat, vorzugsweise YAG:Ce³⁺, oder LuAG:Ce³⁺, oder ein mit seltenen Erden dotiertes Orthosilikat, wie beispielsweise B.O.S.E., umfassen. Der zweite Leuchtstoff 6 kann ein mit Mangan dotiertes KSF, oder ein mit seltenen Erden dotiertes Nitrid, oder ein mit seltenen Erden dotiertes Granat vorzugsweise YAG:Eu³⁺, oder ein mit seltenen Erden dotiertes Yttrium-Oxid, vorzugsweise Y₂O₃:Eu³⁺ umfassen. Spezifische Leuchtstoffe bzw. vorteilhafte Leuchtstoffkombinationen werden später in der Anmeldung gezeigt.

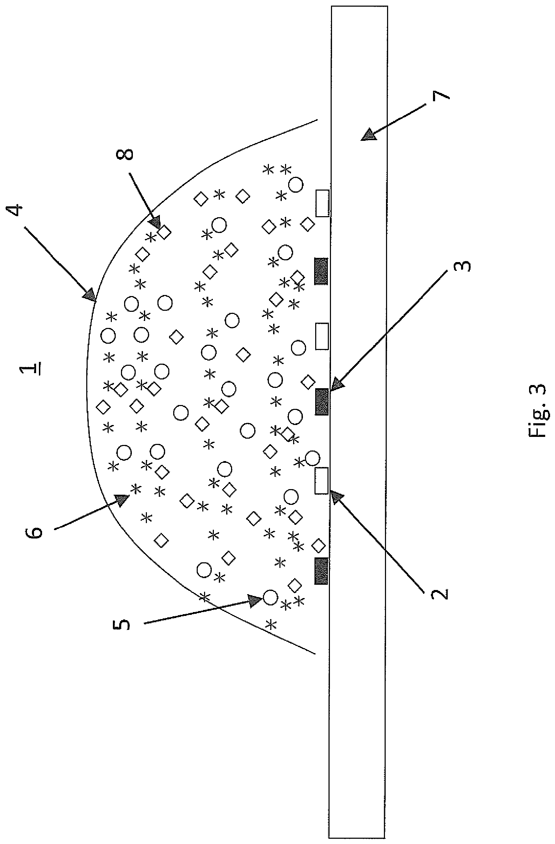

Fig. 3 zeigt ein ähnliches LED-Modul 1, wie es in Figur 2 gezeigt ist. In Fig. 3 ist zusätzlich zu dem ersten Leuchtstoff 5 und dem zweiten Leuchtstoff 6 noch ein dritter Leuchtstoff 8 in der Abdeckung 4 vorhanden, die ein Globe-Top ist.

Dieser dritte Leuchtstoff 8 ist beispielsweise ein mit seltenen Erden dotiertes Granat, vorzugsweise YAG:Ce³⁺, oder LuAG:Ce³⁺, oder ein mit seltenen Erden dotiertes Orthosilikat, vorzugsweise B.O.S.E., und gibt auf Anregung durch das Licht des ersten LED-Chips 2 oder durch das Licht bzw. die UV Strahlung des zweiten LED-Chips 3 vorzugsweise grünes, grünlich-gelbes, gelblich-grünes und/oder gelbes Licht ab.

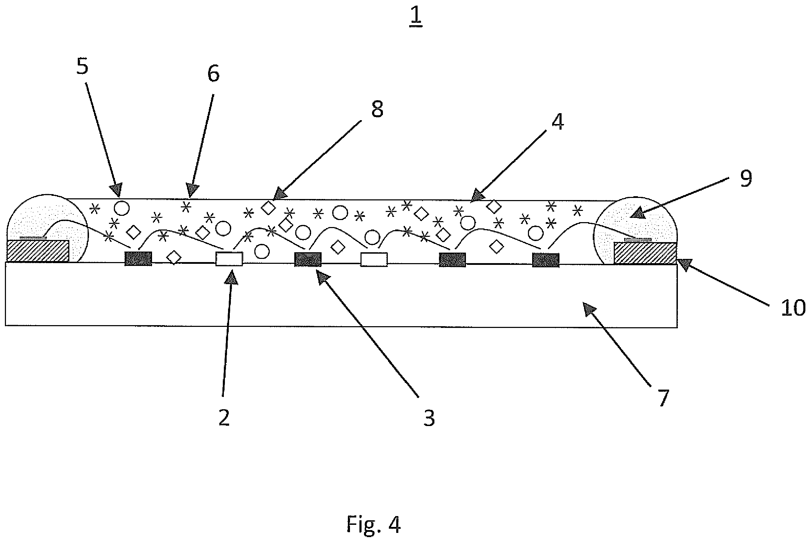

In Fig. 4 ist ein ähnliches LED-Modul 1 gezeigt, wie es in Figur 3 gezeigt ist. Die Abdeckung 4 ist allerdings nun als Füllung eines durch Dämmen und Füllen hergestellten LED-Moduls 1 gebildet. Das derart gebildete LED-Modul 1 weist wenigstens einen Damm 8 auf, vorzugsweise wie gezeigt einen ringförmigen Damm 8, der die einzelnen LED-Chips 2, 3 in seinem inneren einschließt. Zwischen den Damm 8 ist über alle LED-Chips 2,3 die Füllung mit den darin verteilten verschiedenen Leuchtstoffen 5, 6, 8 eingebracht. Es ist in Fig. 4 auch zu sehen, dass die einzelnen LED-Chips 2, 3 mittels nach außerhalb des Damms 8 geleiteter Anschlüsse durch beispielsweise Bonddrähte in Serie verschaltet sind.

Die Basisplatte 7 ist vorzugsweise eine Alanod-Platte, oder eine andere hoch-reflektierende Platte 7, um das Licht der einzelnen LED-Chips 2, 3 bzw. von den Leuchtstoffen 5, 6, 8 zurückgestreutes Licht wieder zu reflektieren, um die Lichtabgabe des LED-Moduls 1 zu erhöhen. Eine solche hoch-reflektierende Platte 7 ist auch für alle gezeigten LED-Module 1 mit Globe-Top als Abdeckung 4 möglich.

Im Folgenden werden nun Beispiele für die oben genannten Ausführungsformen mit besonders vorteilhaften Kombinationen von LED-Chips und Leuchtstoffen beschreiben.

Eine erstes, zweites und drittes Beispiel für die erste Variante der ersten Ausführungsform umfasst jeweils wenigstens einen blauen LED-Chip 2, der ein Intensitätsmaximum in einem Wellenlängenbereich von 455-475 nm aufweist, und wenigstens einen violetten LED-Chip 3, der einen Intensitätsmaximum in einem Wellenlängenbereich von 380-410 nm aufweist.

Im ersten Beispiel wird eine Leuchtstoffmischung in die Abdeckung 4 eingebracht, die aus einem B.O.S.E.-Leuchtstoff (oder alternativ einem Orthosilikat), einer ersten Art von YAG-Leuchtstoff und KSF besteht. Der B.O.S.E.-Leuchtstoff ist dazu geeignet, das Licht des violetten LED-Chips 3 in grünlich-gelbes Licht umzuwandeln. Alle Leuchtstoffe sind ferner dazu geeignet, das Licht des blauen LED-Chips 2 umzuwandeln. Der YAG gibt dabei insbesondere ein gelbes Licht ab, der B.O.S.E.-Leuchtstoff gibt ein grünlich-gelbes Licht ab und das KSF gibt ein rotes Licht ab.

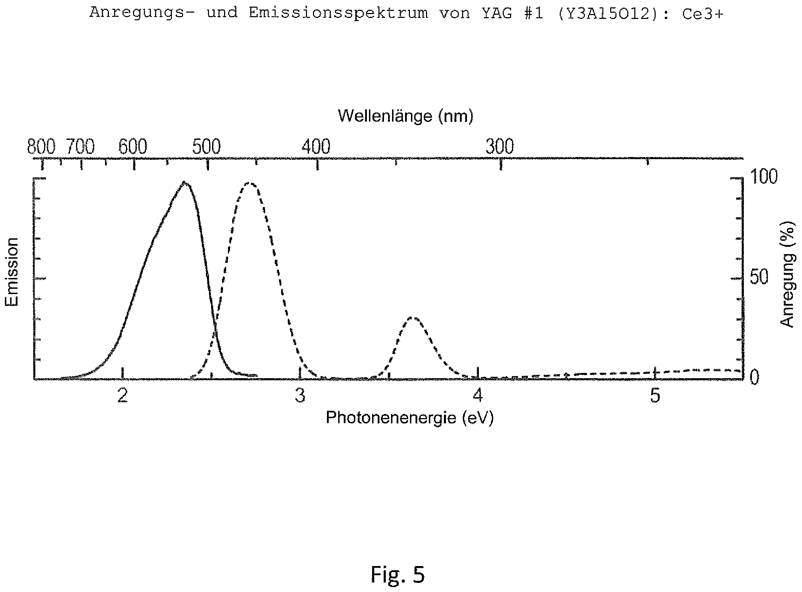

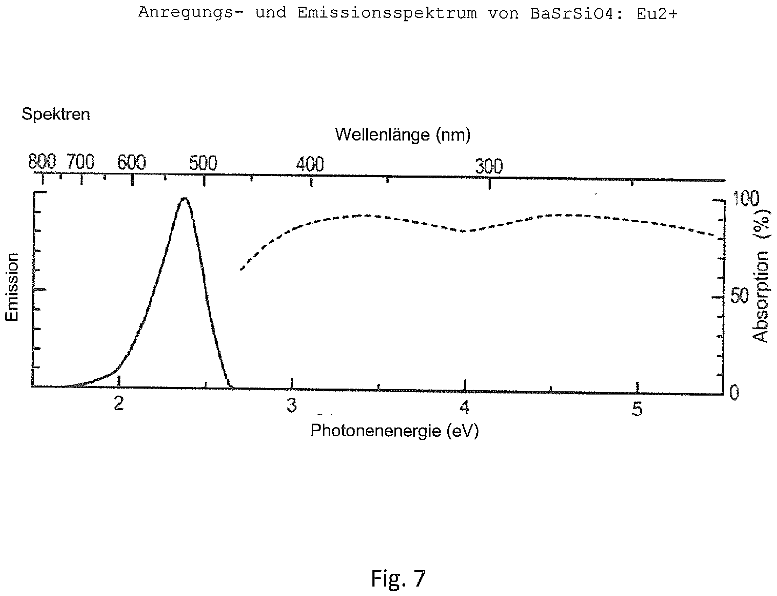

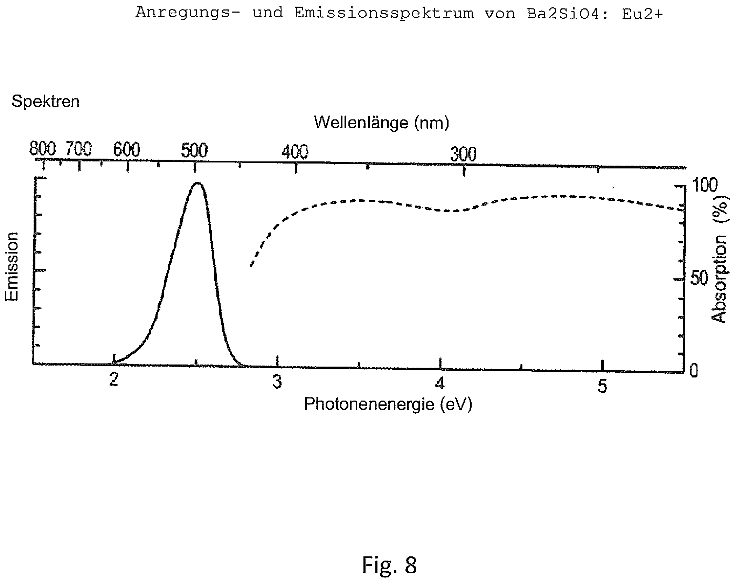

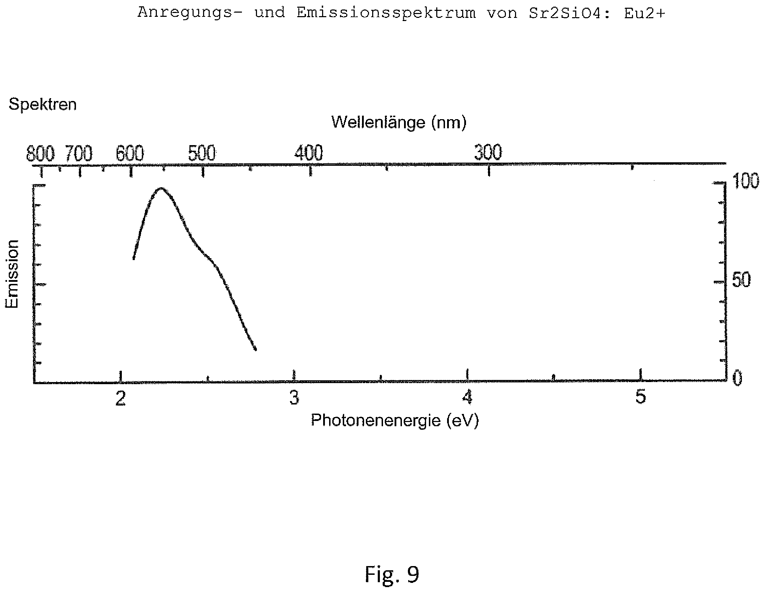

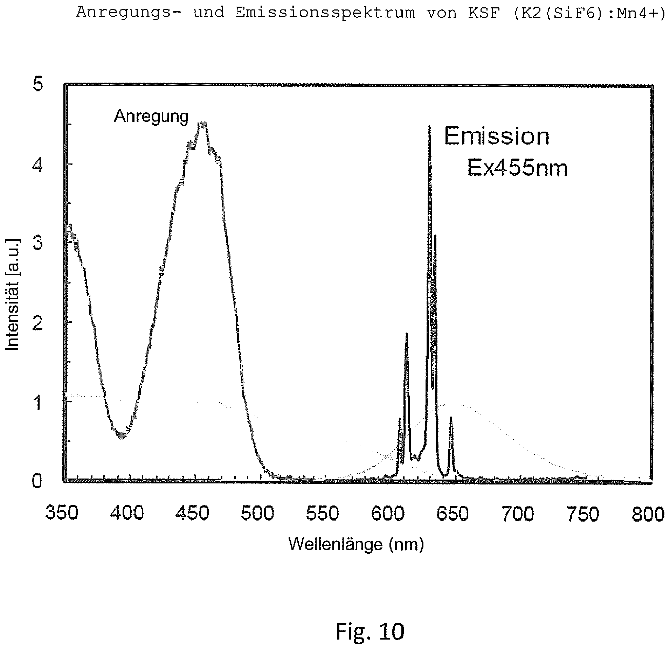

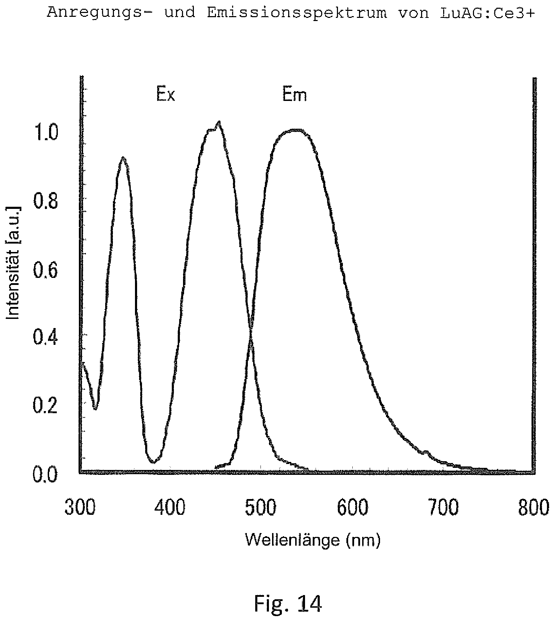

Das Anregungs- und Emissionsspektrum des verwendeten YAG-Leuchtstoffs (Y₃Al₅O₁₂:Ce³⁺) ist in Fig. 5 gezeigt. Alternativ zu dem YAG-Leuchtstoff kann ein LuAG-Leuchtstoff (etwa LuAG:Ce³⁺) verwendet werden, dessen Anregungs- und Emissionsspektrum in Fig. 14 gezeigt ist. Anregung- und Emissionsspektren für verwendbare B.O.S.E.-Leuchtstoffe (BaSrSiO₄: Eu²⁺,Ba₂SiO₄: Eu²⁺ und Sr₂SiO₄: Eu²⁺sind in den Fig. 7 -9 gezeigt. Das Anregungs- und Emissionsspektrum des verwendeten KSF (K₂(SiF₆):Mn⁴⁺) ist in Fig. 10 gezeigt.

Im zweiten Beispiel wird eine Leuchtstoffmischung aus einer zweiten Art von YAG-Leuchtstoff und KSF in die Abdeckung 4 eingebracht. Der YAG ist dazu geeignet, das Licht des violetten LED-Chips 3 umzuwandeln, insbesondere in gelblich-grünes Licht. Beide Leuchtstoffe sind ferner dazu geeignet, das Licht des blauen LED-Chips 3 umzuwandeln. Der YAG gibt dabei insbesondere ein gelbes Licht ab, das KSF gibt ein rotes Licht ab.

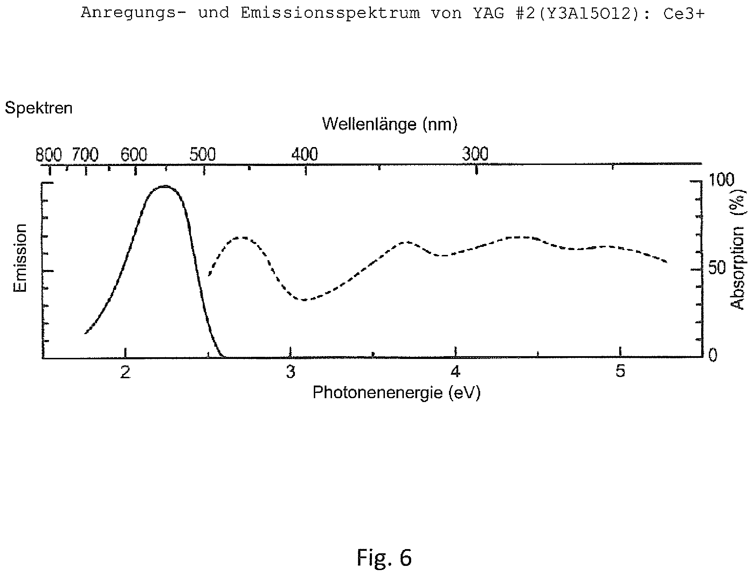

Das Anregungs- und Emissionsspektrum des verwendeten YAG-Leuchtstoffs (Y₃Al₅O₁₂:Ce³⁺) ist in Fig. 6 gezeigt, das Anregungs- und Emissionsspektrum des verwendeten KSF (K₂(SiF₆):Mn⁴⁺) in Fig. 10.

Im dritten Beispiel wird eine Leuchtstoffmischung aus einem B.O.S.E.-Leuchtstoff (alternativ aus einem Orthosilikat), einer ersten Art von YAG-Leuchtstoff und einem Nitrid (z.B. (Sr, Ca)AlSiN₃:Eu²⁺, CaAlSiN₃:Eu²⁺) in die Abdeckung 4 eingebracht. Der B.O.S.E.-Leuchtstoff und das Nitrid sind dazu geeignet, das Licht des violetten LED-Chips 3 umzuwandeln. Der B.O.S.E.-Leuchtstoff strahlt dabei insbesondere grünlich-gelbes Licht ab, das Nitrid rotes Licht. Alle drei Leuchtstoffe sind dazu geeignet, das Licht des blauen LED-Chips 2 umzuwandeln. Der B.O.S.E.-Leuchtstoff strahlt dabei grünlich-gelbes Licht ab, das Nitrid rotes Licht und der YAG gelbes Licht.

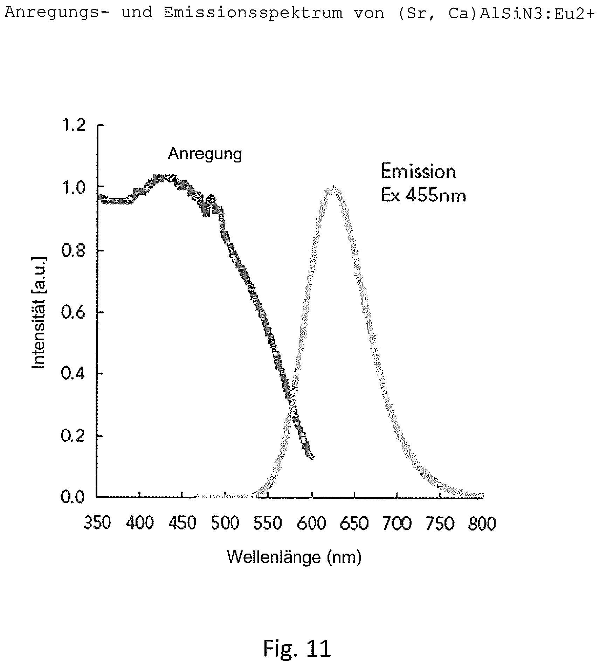

Das Anregungs- und Emissionsspektrum des verwendeten YAG-Leuchtstoffs (Y₃Al₅O₁₂:Ce³⁺) ist in Fig. 5 gezeigt, das Anregungs- und Emissionsspektrum verwendbarer B.O.S.E.-Leuchtstoffe (BaSrSiO₄:Eu²⁺,Ba₂SiO₄:Eu²⁺ und Sr₂SiO₄:Eu²⁺) in Fig. 7-8 und das Anregungs- und Emissionsspektrum des verwendeten Nitrids (Sr, Ca)AlSiN₃:Eu²⁺) in Fig. 11. Alternativ kann statt dem YAG-Leuchtstoff ein LuAG-Leuchtstoff (etwa LuAG:Ce³⁺) verwendet werden, dessen Anregungs- und Emissionsspektrum in Fig. 14 gezeigt ist.

Ein erstes und zweites nicht beanspruchtes Beispiel für die zweite Variante der ersten Ausführungsform umfasst einen blauen LED-Chip 2, der ein Intensitätsmaximum in einem Wellenlängenbereich von 455-475 nm aufweist, und einen UV LED-Chip 3, der ein Intensitätsmaximum in einem Wellenlängenbereich von 230-280 nm aufweist.

Im ersten Beispiel wird eine Leuchtstoffmischung in die Abdeckung 4 eingebracht, die aus einer zweiten Art von YAG-Leuchtstoff und einem YEO-Leuchtstoff besteht (alternativ zu dem YEO-Leuchtstoff einer dritten Art von YAG-Leuchtstoff (YAG:Eu³⁺) besteht). Beide Leuchtstoffe sind dazu geeignet, die Strahlung des UV LED-Chips 3 umzuwandeln, insbesondere der YAG-Leuchtstoff zweiter Art (Fig. 6) in gelbes Licht und der YEO-Leuchtstoff in rotes Licht. Lediglich der YAG-Leuchtstoff zweiter Art ist auch dazu geeignet, das Licht des blauen LED-Chips 2 umzuwandeln, nämlich wiederum in gelbes Licht.

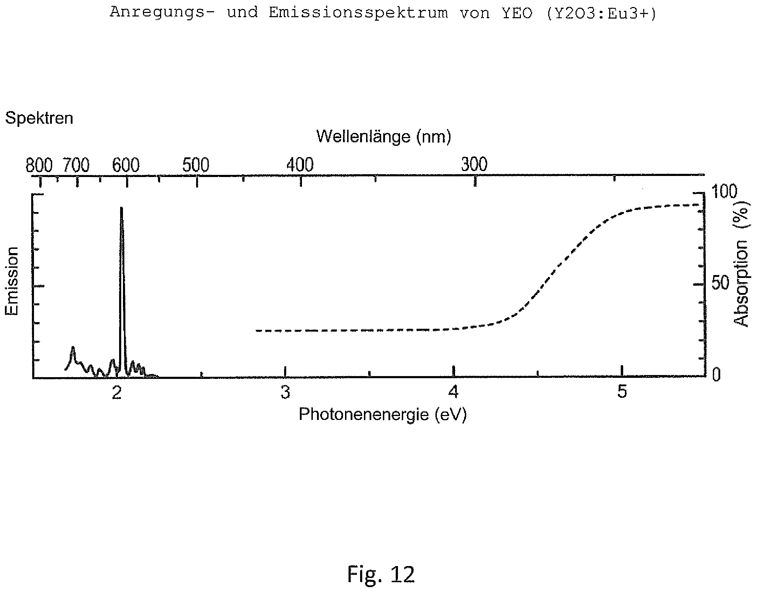

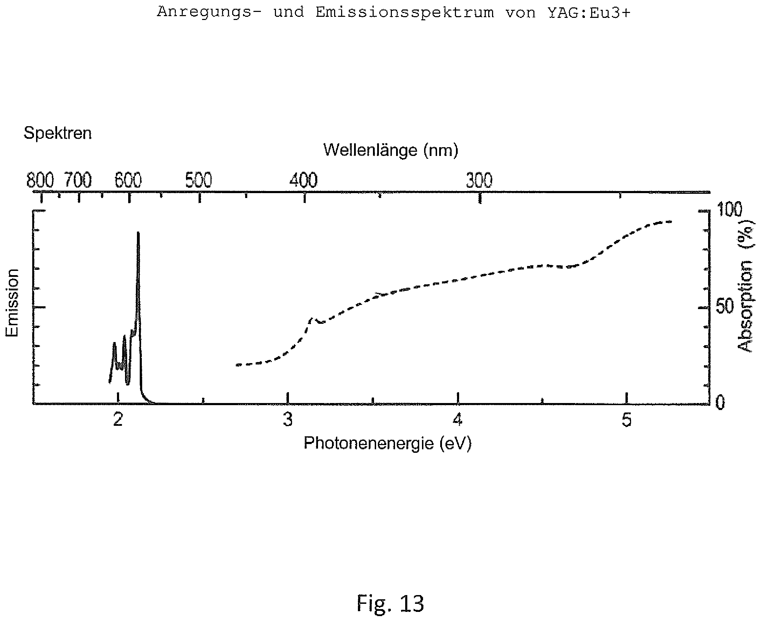

Das Absorptions- und Emissionsspektrum des YAG-Leuchtstoffs (Y₃Al₅O₁₂:Ce³⁺) ist in Fig. 6 gezeigt, das Absorptions- und Emissionsspektrum des YEO-Leuchtstoffs (Y₂O₃:Eu³⁺) ist in Fig. 12 gezeigt. Das Emissions- und Absorptionsspektrum des zu dem YEO-Leuchtstoff alternativen YAG-Leuchtstoff dritter Art (Y₃Al₅O₁₂:Eu³⁺) ist in Fig. 13 gezeigt.

Im zweiten Beispiel wird eine Leuchtstoffmischung aus einem B.O.S.E.-Leuchtstoff, einem YEO-Leuchtstoff (alternativ wieder einem YAG-Leuchtstoff dritter Art) und einer ersten Art von YAG-Leuchtstoff eingebracht. Der B.O.S.E.-Leuchtstoff und der YEO-Leuchtstoff (bzw. YAG dritter Art) sind dazu geeignet, die Strahlung des UV LED-Chips 3 umzuwandeln. Insbesondere strahlt dabei der B.O.S.E.-Leuchtstoff grünlich-gelbes Licht und der YEO-Leuchtstoff (bzw. der YAG dritter Art) rotes Licht ab. Der YAG-Leuchtstoff der ersten Art und der B.O.S.E.-Leuchtstoff sind ferner dazu geeignet, das Licht des blauen LED-Chips 2 umzuwandeln. Insbesondere strahlt dabei der YAG gelbes Licht und der B.O.S.E.-Leuchtstoff grünlich-gelbes Licht ab.

Das Absorptions- und Emissionsspektrum des YAG-Leuchtstoffs erster Art (Y₃Al₅O₁₂:Ce³⁺) ist in Fig. 5 gezeigt, das Absorptions- und Emissionsspektrum des YEO-Leuchtstoffs (Y₂O₃:Eu³⁺) ist in Fig. 12 gezeigt. Das Emissions- und Absorptionsspektrum des zu dem YEO alternativen YAG-Leuchtstoffs dritter Art (Y₃Al₅O₁₂:Eu³⁺) ist in Fig. 13 gezeigt. Anregungs- und Emissionsspektren verwendbarer B.O.S.E.-Leuchtstoffe (BaSrSiO₄: Eu²⁺,Sr₂SiO₄: Eu²⁺ und Ba₂SiO₄: Eu²⁺) sind in Fig. 7-9 gezeigt.

Ein nicht beanspruchtes Beispiel der zweiten Ausführungsform enthält einen ersten UV LED-Chip 2, der ein Intensitätsmaximum bei einer Wellenlänge von 320-360 nm aufweist, und einen zweiten UV LED-Chip 3, der ein Intensitätsmaximum in einem Wellenlängenbereich von 230-280 nm aufweist. Als Leuchtstoffmischung werden ein YAG-Leuchtstoff und ein YEO-Leuchtstoff verwendet. Der YAG (YAG:Ce³⁺, Fig. 5 oder 6) ist insbesondere dazu geeignet, das Licht des ersten UV LED-Chips 2 umzuwandeln, insbesondere in gelbes Licht. Der YEO (Y₂O₃:Eu³⁺, Fig. 12) ist dazu geeignet, das Licht des zweiten UV-LED-Chips 3 umzuwandeln, insbesondere in rotes Licht.

Ein nicht beanspruchtes Beispiel der dritten Ausführungsform umfasst einen blauen LED-Chip 2, der blaues Licht mit einem Intensitätsmaximum in einem Wellenlängenberiech von 400-440 nm aussendet, und einen zweiten blauen LED-Chip 3, der blaues Licht mit einem Intensitätsmaximum in einem Wellenlängenbereich von 430-470 nm aussendet. Als Leuchtstoffmischung wird vorzugsweise eine YAG-Mischung verwendet, dabei können z.B. eine erste und zweite Art von YAG-Leuchtstoff (YAG:Ce³⁺, Fig. 5 und 6) gemischt werden. Die YAG-Leuchtstoffe sind dazu geeignet, das Licht der blauen LED-Chips 2, 3 umzuwandeln, insbesondere ins gelbe, so dass entsprechend einmal wärmeres weißes Licht und einmal kälteres weißes Licht entsteht. Dadurch wird insgesamt ein weißes Licht abstrahlendes LED-Modul 1 mit einer veränderlichen Farbtemperatur erzielt.

Insgesamt ist es für die Erfindung vorteilhaft, dass zumindest teilweise eine separierte Anregung von unterschiedlichen Leuchtstoffarten ermöglicht wird, was dadurch realisiert wird, dass das Anregungs- und Emissionsspektrum der verschiedenen Leuchtstoffe sich nicht überlappen. Dies kann durch gezielte Lücken im Anregungsspektrum erreicht werden.

Insgesamt wird durch die vorliegende Erfindung ein weißes Licht abstrahlendes LED-Modul 1 realisiert, das einfacher hergestellt werden kann, da die verschiedenen Leuchtstoffe einfacher angebracht werden können. Zudem ist durch die Vermischung der verschiedenen Leuchtstoffe in einer einzigen Abdeckung 4, erfindungsgemäß einem einzigen Globe-Top, die Herstellung des LED-Moduls 1 vereinfacht und besser kleineren Strukturgrößen zugänglich. Ferner wird auch die Homogenität des weißen Lichts verbessert. Durch gezieltes Ansteuern der einzelnen verwendeten LED-Chips 2, 3 durch beispielsweise eine AM- oder PWM-Modulation oder ein Einstellen des Vorwärtsstroms kann für das LED-Modul 1 der vorliegenden Erfindung der Farbpunkt bzw. die Farbtemperatur zwischen 2000-6500 K stufenlos eingestellt werden.

## Patentansprüche

1. Weißes Licht abstrahlendes LED-Modul (1), aufweisend
wenigstens einen ersten LED-Chip (2) und wenigstens einen zweiten LED-Chip (3),
eine Abdeckung (4), welche alle LED-Chips (2, 3) abdeckt und mit wenigstens zwei unterschiedlichen Leuchtstoffen (5, 6) versehen ist, wobei
die Abdeckung (4) ein über alle LED-Chips (2, 3) Globe-Top ist,
der erste LED-Chip (2) dazu geeignet ist, blaues Licht mit einem Intensitätsmaximum in einem Wellenlängenbereich von 455 - 475 nm auszusenden,
der zweite LED-Chip (3) dazu geeignet ist, violettes Licht mit einem Intensitätsmaximum in einem Wellenlängenbereich von 380 - 410 nm, vorzugsweise bei einer Wellenlänge von etwa 405 nm, auszusenden,
ein erster Leuchtstoff (5) dazu geeignet ist, das blaue Licht des ersten LED-Chips (2) und/oder das violette Licht des zweiten LED-Chips (3) zumindest teilweise in grünes, grünlich-gelbes, gelblich-grünes und/oder gelbes erstes Licht umzuwandeln, und
ein zweiter Leuchtstoff (6) dazu geeignet ist, das violette Licht des zweiten LED-Chips (3) und/oder das blaue Licht des ersten LED-Chips (2) zumindest teilweise in rotes zweites Licht umzuwandeln,
wobei ein Maximum im Anregungsspektrum des einen Leuchtstoffs (5, 6) nicht mit einem Maximum im Emissionsspektrum des anderen Leuchtstoffs (6, 5) überlappt,
wobei das weiße Licht des LED-Moduls (1) zumindest das erste und das zweite Licht enthält, und
Farbkoordinaten des weißen Lichts durch Einstellen der Intensität und/oder Wellenlänge der Strahlung des ersten und/oder zweiten LED-Chips (2, 3) veränderbar sind.

2. LED-Modul (1) nach Anspruch 1, wobei
die Intensität der Strahlung des ersten und/oder zweiten LED-Chips (2, 3) durch Amplituden- oder Pulsweiten-Modulation veränderbar ist, und/oder
die Wellenlänge der Strahlung des ersten und/oder zweiten LED-Chips (2, 3) über den Vorwärtsstrom veränderbar ist.

3. LED-Modul (1) nach Anspruch 1, wobei
der erste Leuchtstoff (5) dazu geeignet ist, das blaue Licht des ersten LED-Chips (2) und/oder das violette Licht des zweiten LED-Chips (3) nur teilweise in das erste Licht umzuwandeln, so dass eine Mischung des nicht umgewandelten Lichts und des ersten Lichts ein weißes Licht ergibt, und
das weiße Licht des LED-Moduls (1) zumindest das weiße Licht bestehend aus dem nicht umgewandelten Licht und dem ersten Licht sowie das zweite Licht enthält.

4. LED-Modul (1) nach einem der Ansprüche 1 bis 3, wobei
die Abdeckung (4) mit einem dritten Leuchtstoff (8) versehen ist,
der dritte Leuchtstoff (8) dazu geeignet ist, das blaue Licht des ersten LED-Chips (2) und/oder die UV Strahlung oder das violette Licht des zweiten LED-Chips (3) zumindest teilweise in grünes, grünlich-gelbes, gelblich-grünes und/oder gelbes drittes Licht umzuwandeln und
das weiße Licht des LED-Moduls (1) das dritte Licht enthält.

5. LED-Modul (1) nach Anspruch 4, wobei
der dritte Leuchtstoff (8) ein mit seltenen Erden dotiertes Granat, vorzugsweise YAG:Ce³⁺, oder LuAG:Ce³⁺, oder ein mit seltenen Erden dotiertes Orthosilikat, vorzugsweise B.O.S.E., umfasst.

6. LED-Modul (1) nach einem der Ansprüche 1 bis 5, wobei
der erste Leuchtstoff (5) ein mit seltenen Erden dotiertes Granat, vorzugsweise YAG:Ce³⁺, oder LuAG:Ce³⁺, oder ein mit seltenen Erden dotiertes Orthosilikat, vorzugsweise B.O.S.E., umfasst und
der zweite Leuchtstoff (6) ein mit Mangan dotiertes KSF oder ein mit seltenen Erden dotiertes Nitrid umfasst.

## Claims

1. A white light-radiating LED module (1), comprising
at least one first LED chip (2) and at least one second LED chip (3),
a cover (4) covering all LED chips (2, 3) and equipped with at least two different illuminants (5, 6), wherein
the cover (4) is a globe top across all LED chips (2, 3),
the first LED chip (2) is suitable for emitting blue light with an intensity maximum in a wavelength range of 455-475 nm,
the second LED chip (3) is suitable for emitting violet light having an intensity maximum in a wavelength range of 380-410 nm, preferably at a wavelength of approximately 405 nm,
a first illuminant material (5) is suitable for at least partially converting the blue light of the first LED chip (2) and/or the violet light of the second LED chip (3) into green, greenish-yellow, yellowish-green, and/or yellow first light, and
a second illuminant (6) is suitable for at least partially converting the violet light of the second LED chip (3) and/or the blue light of the first LED chip (2) into red second light,
wherein a maximum in the excitation spectrum of the one illuminant (5, 6) does not overlap with a maximum in the emission spectrum of the other illuminant (6, 5),
wherein the white light of the LED module (1) contains at least the first and second light, and
color coordinates of the white light are changeable by adjusting the intensity and/or wavelength of the radiation of the first and/or second LED chip (2, 3).

2. The LED module (1) according to claim 1, wherein
the intensity of the radiation of the first and/or second LED chip (2, 3) is changeable by amplitude or pulse width modulation, and/or
the wavelength of the radiation of the first and/or second LED chip (2, 3) is changeable by the forward current.

3. The LED module (1) according to claim 1, wherein
the first illuminant (5) is suitable for only partially converting the blue light of the first LED chip (2) and/or the violet light of the second LED chip (3) into the first light so that a mixture of the non-converted light and the first light yields a white light, and
the white light of the LED module (1) contains at least the white light consisting of the non-converted light and the first light as well as the second light.

4. The LED module (1) according to any one of claims 1 to 3, wherein
the cover (4) is equipped with a third illuminant (8),
the third illuminant (8) is suitable for at least partially converting the blue light of the first LED chip (2) and/or the UV radiation or the violet light of the second LED chip (3) into green, greenish-yellow, yellowish-green, and/or yellow third light, and
the white light of the LED module (1) contains the third light.

5. The LED module (1) according to claim 4, wherein
the third illuminant (8) comprises a garnet, preferably YAG:Ce³⁺ or LuAG:Ce³⁺, doped with rare earth, or an orthosilicate, preferably B.O.S.E., doped with rare earth.

6. The LED module (1) according to any one of claims 1 to 5, wherein
the first illuminant (5) comprises a garnet, preferably YAG:Ce³⁺ or LuAG:Ce³⁺, doped with rare earth, or an orthosilicate, preferably B.O.S.E., doped with rare earth, and
the second illuminant (6) comprises a KSF doped with manganese or a nitride doped with rare earth.

## Revendications

1. Module à LED (1) émettant de la lumière blanche, présentant
au moins une première puce LED (2) et au moins une deuxième puce LED (3),
un organe de couverture (4) recouvrant toutes les puces LED (2, 3) et doté d'au moins deux luminophores (5, 6) différents, étant entendu que
l'organe de couverture (4) est un globe de couverture recouvrant toutes les puces LED (2, 3),
la première puce LED (2) est apte à envoyer de la lumière bleue avec un maximum d'intensité situé dans une plage de longueurs d'onde de 455 à 475 nm,
la deuxième puce LED (3) est apte à envoyer de la lumière violette avec un maximum d'intensité situé dans une plage de longueurs d'onde de 380 à 410 nm, de préférence à une longueur d'onde de 405 nm,
un premier luminophore (5) est apte à transformer au moins partiellement la lumière bleue de la première puce LED (2) et/ou la lumière violette de la deuxième puce LED (3) en une première lumière verte, jaune-verdâtre, vert-jaunâtre et/ou jaune, et
un deuxième luminophore (6) est apte à transformer au moins partiellement la lumière violette de la deuxième puce LED (3) et/ou la lumière bleue de la première puce LED (2) en une deuxième lumière rouge ,
le maximum du spectre d'excitation d'un luminophore (5, 6) n'étant pas en superposition avec le maximum du spectre d'émission de l'autre luminophore (6, 5),
la lumière blanche du module à LED (1) contenant au moins la première et la deuxième lumière, et
les coordonnées de couleur de la lumière blanche étant modifiables par réglage de l'intensité et/ou de la longueur d'onde de la première et/ou de la deuxième puce LED (2, 3).

2. Module à LED (1) selon la revendication 1, dans lequel
l'intensité du rayonnement de la première et/ou de la deuxième puce LED (2, 3) peut être modifiée par modulation d'amplitude ou de largeur d'impulsion, et/ou
la longueur d'onde du rayonnement de la première et/ou de la deuxième puce LED (2, 3) peut être modifiée par l'intermédiaire du courant direct.

3. Module à LED (1) selon la revendication 1, dans lequel
la premier luminophore (5) est apte à transformer uniquement partiellement la lumière bleue de la première puce LED (2) et/ou la lumière violette de la deuxième puce LED (3) en ladite première lumière de telle manière qu'un mélange de la lumière non transformée et de la première lumière produise une lumière blanche, et
la lumière blanche du module à LED (1) contient au moins la lumière blanche composée de la lumière non transformée et de la première lumière ainsi que la deuxième lumière.

4. Module à LED (1) selon l'une des revendications 1 à 3, dans lequel
l'organe de couverture (4) est doté d'un troisième luminophore (8),
le troisième luminophore (8) est apte à transformer au moins partiellement la lumière bleue de la première puce LED (2) et/ou le rayonnement UV ou la lumière violette de la deuxième puce LED (3) en une troisième lumière verte, jaune-verdâtre, vert-jaunâtre et/ou jaune, et
la lumière blanche du module à LED (1) contient la troisième lumière.

5. Module à LED (1) selon la revendication 4, dans lequel
le troisième luminophore (8) comprend un grenat dopé aux terres rares, de préférence YAG:Ce³⁺ ou LuAG:Ce³⁺, ou un orthosilicate dopé aux terres rares, de préférence B.O.S.E..

6. Module à LED (1) selon l'une des revendications 1 à 5, dans lequel
le premier luminophore (5) comprend un grenat dopé aux terres rares, de préférence YAG:Ce³⁺ ou LuAG:Ce³⁺, ou un orthosilicate dopé aux terres rares, de préférence B.O.S.E., et
le deuxième luminophore (6) comprend un KSF dopé au manganèse ou un nitrure dopé aux terres rares.
